Europäisches Patentamt

European Patent Office

Office européen des brevets

(1) Publication number:

**0 096 349**
**B1**

## EUROPEAN PATENT SPECIFICATION

(45) Date of publication of patent specification: **07.05.86**

(21) Application number: **83105396.2**

(22) Date of filing: **31.05.83**

(51) Int. Cl.⁴: **H 03 F 3/45,** G 01 R 17/16,
G 01 R 19/10

(54) **Comparator circuit.**

(30) Priority: **09.06.82 JP 98761/82**

(43) Date of publication of application:
**21.12.83 Bulletin 83/51**

(45) Publication of the grant of the patent:
**07.05.86 Bulletin 86/19**

(84) Designated Contracting States:
**DE FR GB**

(56) References cited:
DE-B-2 850 487
US-A-4 092 612

IEEE JOURNAL OF SOLID-STATE CIRCUITS,
vol. SC-16, no. 6, December 1981, New-York
ROBERT A. BLAUSCHILD "An Open Loop
Programmable Amplifier with Extended
Frequency Range", pages 626-633

DATABOOK RCA INTEGRATED CRICUITS, April
1976, RCA-Corporation, Somerville, New-York
"Quad Voltage Comparators", page 37

(73) Proprietor: **Kabushiki Kaisha Toshiba**
**72, Horikawa-cho Saiwai-ku**
**Kawasaki-shi Kanagawa-ken 210 (JP)**

(72) Inventor: **Oida, Yoshio**
**4-1-2-201, Maiharahigashi**
**Funabashi-shi Chiba-ken (JP)**

(74) Representative: **Henkel, Feiler, Hänzel & Partner**
**Möhlstrasse 37**
**D-8000 München 80 (DE)**

## Description

The present invention relates to a comparator circuit for obtaining a comparison output by comparing an output voltage with a reference voltage. Such comparator circuit is extensively used as a circuit for effecting level conversion, voltage comparison, etc.

Document "RCA Integrated Circuits", April 1976, RCA Corporation, Somerville, N.J., USA, page 37, discloses a voltage comparator circuit in which first and second transistors of one conductivity type have their emitters connected to a common junction. A first constant current source is connected between this common junction and a first DC power source terminal, and a reference voltage is applied to the base of the first transistor. The input voltage to be compared is applied to the base of the second transistor. Furthermore, third and fourth transistors of the other conductivity type have their bases connected to each other, and their emitters are connected to a second power source terminal. The collector and base of the third transistor are connected to the collector of the first transistor. A fifth transistor has its base connected to the collector of the fourth transistor and its emitter connected to the second DC power source terminal, in which the output voltage is a result of comparison made between the reference voltage and the input voltage.

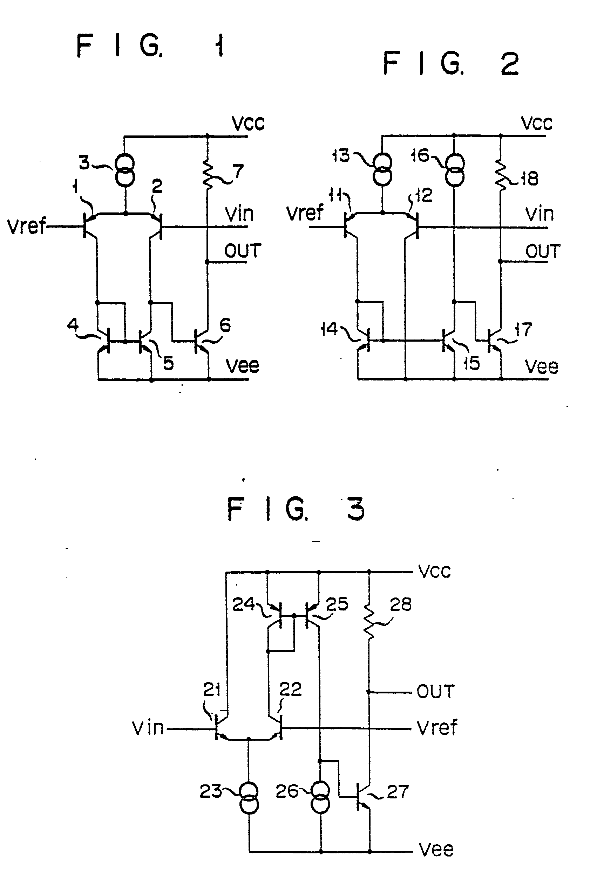

Fig. 1 is a circuit diagram showing one form of known voltage comparators. A pair of transistors of one conductivity type, that is, a pair of PNP type transistors 1, 2 constituting a differential circuit have their emitters connected through a common constant current source 3 to one terminal Vcc of a DC power source. A reference voltage Vref is applied to the base of one (transistor 1) of the transistors 1, 2 and an input voltage Vin to be compared is applied to the base of the other transistor 2. A current mirror circuit is connected as a load to the collectors of the transistors 1, 2 and comprised of a pair of transistors (i.e., NPN type transistors 4, 5) different in conductivity type from the pair of transistors 1, 2. The base and emitter of the transistor 4 are respectively connected to the base and emitter of the transistor 5, and the emitters of the transistors 4, 5 are connected to the other terminal Vee of the DC power source. The collectors of the transistors 4, 5 in the current mirror circuit are connected to the corresponding collectors of the transistors 1, 2 in the differential circuit. The transistor 5 of the current mirror circuit has its collector connected to the base of an output transistor 6, and the base and collector of the transistor 4 of the current mirror circuit are connected to each other. The output transistor 6 has its emitter connected to the terminal Vee· of the power source and its collector connected to an output OUT and to the terminal Vcc of the power source through a load resistor 7. It is to be noted that a predetermined voltage of a positive polarity is supplied from the terminal Vcc of the power source and a predetermined voltage of a negative polarity is supplied from the terminal Vee of the power source.

In the normal operation state, for example, with Vin≧Vref, one transistor 1 of the differential circuit is turned ON and the other transistor is turned OFF. In consequence, the transistors 4, 5 in the current mirror circuit are turned ON and the output transistor is turned OFF since no base current is supplied to the output transistor 6. The output OUT becomes an "H" level. With Vin<Vref, the transistor 1 of the differential circuit is turned OFF and the transistor 2 is turned ON. Consequently, both the transistors 4, 5 in the current mirror circuit are turned OFF and the output transistor 6 is turned ON since it has its base supplied with a current from the constant current source. The output OUT becomes an "L" level. Now suppose that a potential the same as that on the terminal Vee of the power source is applied to the input terminal Vin. With Vce (1) representing a collector-to-emitter voltage of the transistor 1, Vbe (1) a base-to-emitter voltage of the transistor 1 and Vbe (6) a base-to-emitter voltage of the transistor 6, the following equation is established:

$$Vce\ (1) = Vbe\ (1) - Vbe\ (6)$$
$$\simeq 0$$

That is, the collector-to-emitter voltage of the transistor 1 of the differential circuit is given as a value obtained by subtracting the base-to-emitter voltage Vbe (6) of the output transistor 6 from the base-to-emitter voltage Vbe (1) of the transistor 1. This value becomes substantially zero. For this reason, the transistor 1 does not act as a transistor and the emitter-to-base circuit of the transistor 1 acts as a mere diode. In this state, all the current from the constant current source 3 flows from the base of the transistor 1 and ceases to flow into the base of the output transistor 6. At this time, the output transistor 6 becomes an unstable, near-OFF state, resulting in an erroneous operation.

Recently, use has been made of various electronic apparatus using an electric cell, solar cell, etc. In general, it is preferable that such electronic apparatus be of a compact, light-weight type. This unavoidably requires a small-capacity and low voltage level cell. In such an apparatus, the comparator circuit as shown in Fig. 1 is used and mechanical component parts such as a motor and solenoid are driven by using a common power source. In a particular situation where sufficient electromotive force is not obtained from the electric cell, a relatively large current flows through the mechanical part during the starting time, lowering the power source voltage, thereby causing faulty operation.

One object of this invention is to provide a comparator circuit which can be normally operated even when an input voltage applied to one of the transistors constituting a differential circuit comes very near to the collector potential of the transistor or exceeds the collector potential of the transistor.

Another object of this invention is to provide a comparator which can reduce a power source voltage level and permits a wider choice of an input voltage.

According to this invention, there is provided a comparator circuit for obtaining a comparison output by comparing an input voltage with a reference voltage, comprising: first and second transistors of one conductivity type having their emitters connected to a common junction, a first constant current source connected between said common junction and a first DC power source terminal, means for applying a reference voltage to the base of the first transistor, means for applying an input voltage to be compared to the base of the second transistor, third and fourth transistors of the other conductivity type having their bases connected to each other, means for connecting the emitters of the third and fourth transistors to a second power source terminal, means for connecting the collector and base of the third transistor to the collector of the first transistor, and a fifth transistor having its base connected to the collector of the fourth transistor and its emitter connected to the second DC power source terminal, in which a result of comparison made between the reference voltage and the input voltage is output through the collector of the fifth transistor, said comparator circuit being characterized by means for connecting the collector of the second transistor to the second DC power source terminal, and a second constant current source connected between the collector of the fourth transistor and the first DC power source terminal.

The present invention provides a comparator circuit which is capable of surely operating even with respect to an input voltage having a wide range and in which a power source voltage level can be reduced. This stable operation is also ensured when the input voltage applied to the base of the second transistor comes very near to the collector potential of this transistor or exceeds the collector potential.

The comparator circuit comprises a pair of transistors in a differential circuit which are supplied with an input signal and which are connected in an emitter-follower configuration and a current mirror circuit connected to the collector of a transistor on a reference voltage side of the differential circuit in which the current mirror circuit is driven by a constant current source.

This invention can be more fully understood from the following detailed description when taken in conjunction with the accompanying drawings, in which:

Fig. 1 is a circuit diagram showing a conventional comparator circuit;

Fig. 2 is a circuit diagram showing a comparator circuit according to an embodiment of this invention; and

Fig. 3 is a circuit diagram showing one modified form of the comparator circuit of this invention.

The embodiments of this invention will be explained below by referring to the accompanying drawings.

Fig. 2 is a circuit diagram showing a comparator circuit according to one embodiment of this invention. In Fig. 2, a pair of transistors 11, 12 of, for example, PNP types have their emitters connected through a first constant current source 13 to one terminal Vcc of a DC power source to provide a differential circuit. A reference voltage Vref is applied to the base of one (11) of the paired transistors 11, 12 and an input voltage Vin to be compared is applied to the base of the other transistor 12. A transistor 14 on the input side of a current mirror circuit is connected to the collector side of the transistor 11 in the differential circuit. The transistor 12 of the differential circuit has its collector connected to the other terminal Vee of the power source. A transistor 15 on the output side of the current mirror circuit has its collector connected through a second constant current source 16 to the terminal Vcc of the power source and its emitter connected to the terminal Vee of the power source. The transistor 15 has its collector connected to the base of an output transistor 17. The output transistor 17 has its collector connected to an output OUT and through a load resistor 18 to the terminal Vcc of the power source and its emitter connected to the terminal Vee of the power source.

With Vin≧Vref, for example, the transistor 11 is turned ON, since the transistor 12 of the differential circuit is connected, in an emitter-coupled configuration or an emitter follower configuration, with respect to the transistor 11. A current from the first constant current source 13 flows into the terminal Vee of the power source through the transistor 11 and the transistor 14 in the current mirror circuit. If the transistor 14, 15 in the current mirror circuit have the same characteristics, the current through the input side transistor 14 in the current mirror circuit becomes equal to the current through the output side transistor 15 in the current mirror circuit. With the currents of the first and second constant current sources 13 and 16 set to a ratio of 2:1 the output side transistor 15 has an insufficient amount of current supplied from the base of the output transistor 17. Thus, the output transistor 17 is turned OFF and the output OUT becomes an "H" level.

With Vin<Vref, the transistor 12 of the differential circuit is turned ON and a current of the first constant source 13 flows through the transistor 12 into the terminal Vee of the power source. Since no current flows through the transistor 11, the transistors in the current mirror circuit are turned OFF. The current of the second constant current source 16 flows into the base of the output transistor 17. As a result, the transistor 17 is turned ON and the output OUT becomes an "L" level.

With Vin=Vee, that is, when the input voltage

Vin becomes equal to the collector potential of the input side transistor 12, a forward drop voltage across the base-to-emitter circuit of the transistor 12 occurs due to a potential on the collector-to-emitter circuit of the transistor. The value of the forward drop voltage Vbe will be, for example, of the order of 0.6 V. Even if the base potential on the transistor 12 is equal to the collector potential on the transistor 12 or the collector potential exceeds, for example, about 0.3 V, the transistor is activated. Even in this state, the transistor can maintain a normal state, i.e., a stable ON state. In this case, the limit of the logical operation is considered to be Vce (1)>0, that is, Vin∼Vec–Vbe (1). Even if Vin<Vee, the circuit can perform a normal operation. In this case, there is a possibility that, if the input voltage Vin level becomes too low, the circuit will not perform a normal operation due to the flow of the current from the terminal Vee of the power source to the base of the transistor 12.

Suppose that with respect to the threshold level of the comparator, the current level of the first constant current sources 13 is equal to that of the second constant current source 16 and the areas of the emitters of the transistors 14 and 15 in the current mirror circuit are set to 1:2, the comparator circuit of this invention can obtain the same characteristic as that shown in Fig. 1. In this case, the threshold voltage level will become the reference voltage Vref level.

This invention is not restricted to the above-mentioned embodiment. Although in the above-mentioned embodiment the PNP type transistors have been explained as being used for the differential circuit, NPN transistors 21, 22 as shown in Fig. 3 may be used for the differential circuit. In this case, a pair of NPN type transistors 21, 22 have their emitters connected through a common junction and first constant current source 23 to a terminal Vec of a power source. The transistor 21 has its collector connected directly to a terminal Vcc of the power source. The transistor 22 has its collector connected through an input side of a current mirror circuit to the terminal Vcc of the power source. The current mirror circuit comprises a pair of transistors (PNP type), 24, 25 different in conductivity type from those of the differential circuit. The input side transistor 24 has its base and collector connected through a common junction to the collector of the transistor 22 and its emitter connected to the terminal Vcc of the power source. The output side transistor 25 has its emitter connected to the terminal Vcc of the power source and its collector connected to the terminal Vee through a second constant current source 26 and to the base of an output transistor 27. The output transistor 27 has its emitter connected to the terminal Vee of the power source and its collector connected to an output OUT and to the terminal Vcc of the power source through a resistor 28.

The embodiment of Fig. 3 permits an operable range of the input voltage to be extended more to the collector potential side of the transistor of the differential circuit as in the case of the embodiment of Fig. 2.

The current ratio between the transistors 14 and 15 or between 24 and 25 can be set by an emitter area ratio between these transistors or by a resistor connected between the power source terminal Vee and the emitter of these transistors.

**Claims**

1. A comparator circuit for obtaining a comparison output by comparing an input voltage with a reference voltage, comprising:
first and second transistors (11, 12; 21, 22) of one conductivity type having their emitters connected to a common junction;
a first constant current source (13; 23) connected between said common junction and a first DC power source terminal;
means for applying a reference voltage to the base of the first transistor (11; 22);
means for applying an input voltage to be compared to the base of the second transistor (12; 21);
third and fourth transistors (14, 15; 24, 25) of the other conductivity type having their bases connected to each other;
means for connecting the emitters of the third and fourth transistors (14, 15; 24, 25) to a second power source terminal;
means for connecting the collector and base of the third transistor (14; 24) to the collector of the first transistor (11; 22); and
a fifth transistor (17; 27) having its base connected to the collector of the fourth transistor (15; 25) and its emitter connected to the second DC power source terminal,
in which a result of comparison made between the reference voltage and the input voltage is output through the collector of the fifth transistor (17; 27),
characterized by means for connecting the collector of the second transistor (12; 21) to the second DC power source terminal; and
a second constant current source (16; 26) connected between the collector of the fourth transistor (15; 25) and the first DC power source terminal.

2. A comparator circuit according to claim 1, characterized in that said third transistor (14; 24) has an emitter area n-times that of said fourth transistor (15; 25) and the setting current of said second constant current source (16; 26) is made n/2 times that of said first constant current source (13; 23).

3. A comparator circuit according to claim 1, characterized in that n is equal to 1.

4. A comparator circuit according to claim 1, characterized in that the current value of said first constant current source (13; 23) is equal to that of said second constant current source (16; 26) and said fourth transistor (15; 25) has an emitter area twice that of said third transistor (14; 24).

**Patentansprüche**

1. Komparatorschaltung zur Lieferung eines Vergleichsausgangssignals durch Vergleichen einer Eingangsspannung mit einer Bezugsspannung, umfassend

erste und zweite Transistoren (11, 12; 21, 22) des einen Leitfähigkeitstyps, deren Emitter mit einer gemeinsamen Verzweigung verbunden sind,

eine zwischen die gemeinsame Verzweigung und einen ersten Gleichstromquellenanschluß geschaltete erste Konstantstromquelle (13; 23),

eine Einrichtung zum Anlegen einer Bezugsspannung an die Basis des ersten Transistors (11; 22),

eine Einrichtung zum Anlegen einer zu vergleichenden Eingangsspannung an die Basis des zweiten Transistors (12; 21),

dritte und vierte Transistoren (14, 15; 24, 25) des anderen Leitfähigkeitstyps, deren Basiselektroden zusammengeschaltet sind,

eine Einrichtung zum Verbinden der Emitter der dritten und vierten Transistoren (14, 15; 24, 25) mit einem zweiten Stromquellenanschluß,

eine Einrichtung zum Verbinden von Kollektor und Basis des dritten Transistors (14; 24) mit dem Kollektor des ersten Transistors (11, 22) und

einen fünften Transistor (17; 27), dessen Basis mit dem Kollektor des vierten Transistors (15; 25) und dessen Emitter mit dem zweiten Gleichstromquellenanschluß verbunden sind,

wobei ein Ergebnis eines zwischen der Bezugsspannung und der Eingangsspannung angestellten Vergleichs über den Kollektor des fünften Transistors (17; 27) ausgebbar ist,

gekennzeichnet, durch eine Einrichtung zum Verbinden des Kollektors des zweiten Transistors (12; 21) mit dem zweiten Gleichstromquellenanschluß und

eine zwischen den Kollektor des vierten Transistors (15; 25) und den ersten Gleichstromquellenanschluß geschaltete zweite Konstantstromquelle (16; 26).

2. Komparatorschaltung nach Anspruch 1, dadurch gekennzeichnet, daß der dritte Transistor (14; 24) eine Emitterfläche entsprechend dem n-fachen derjenigen des vierten Transistors (15; 25) aufweist und der Soll- oder Vorgabestrom der zweiten Konstantstromquelle (16; 26) auf das n/2-fache desjenigen der ersten Konstantstromquelle (13; 23) eingestellt ist.

3. Komparatorschaltung nach Anspruch 1, dadurch gekennzeichnet, daß n gleich 1 ist.

4. Komparatorschaltung nach Anspruch 1, dadurch gekennzeichnet, daß die Stromgröße der ersten Konstantstromquelle (13; 23) derjenigen der zweiten Konstantstromquelle (16; 26) gleich ist und der vierte Transistor (15; 25) eine Emitterfläche entsprechend dem Doppelten derjenigen des dritten Transistors (14; 24) aufweist.

**Revendications**

1. Circuit comparateur destiné à produire un signal de sortie de comparaison en comparant une tension d'entrée avec une tension de référence, comprenant:

— un premier et un second transistor (11, 12; 21, 22) d'un type de conductivité, dont les émetteurs sont connectés à une jonction commune;
— une première source de courant constant (13; 23) branchée entre cette jonction commune et une première borne d'une source d'alimentation à courant continu;
— un moyen pour appliquer une tension de référence à la base du premier transistor (11; 22);
— un moyen pour appliquer une tension d'entrée à comparer à la base du second transistor (12; 21);
— un troisième et un quatrième transistor (14, 15; 24, 25) de l'autre type de conductivité, dont les bases sont connectées l'une à l'autre;
— un moyen pour relier les émetteurs des troisième et quatrième transistors (14, 15; 24, 25) à une seconde borne de la source d'alimentation;
— un moyen pour relier le collecteur et la base du troisième transistor (14; 24) au collecteur du premier transistor (11; 22); et
— un cinquième transistor (17; 27) connecté par sa base au collecteur du quatrième transistor (15; 25) et par son émetteur à la second borne de la source d'alimentation à courant continu,

circuit dans lequel le résultat de la comparaison effectué entre la tension de référence et la tension d'entrée est délivré en tant que signal de sortie par le collecteur du cinquième transistor (17; 27), caractérisé par un moyen pour relier la collecteur du second transistor (12; 21) à la seconde borne de la source d'alimentation à courant continu et par une deuxième source de courant constant (16; 26) branchée entre le collecteur du quatrième transistor (15; 25) et la première borne de la source d'alimentation à courant continu.

2. Circuit comparateur selon la revendication 1, caractérisé en ce que le troisième transistor (14; 24) possède une aire d'émetteur correspondant à n fois celle du quatrième transistor (15; 25) et le courant de réglage de la deuxième source de courant constant (16; 26) est rendu égal à n/2 fois celui de la première source de courant constant (13; 23).

3. Circuit comparateur selon la revendication 1, caractérisé en ce que n est égal à 1.

4. Circuit comparateur selon la revendication 1, caractérisé en ce que l'intensité du courant de la première source de courant constant (13, 23) est égale à celle de la deuxième source de courant constant (16; 26) et le quatrième transistor (15; 25) possède une aire d'émetteur deux fois plus grande que celle du troisième transistor (14; 24).

FIG. 1

FIG. 2

FIG. 3